# EUROPÄISCHE PATENTSCHRIFT

(11) **EP 2 061 293 B1**
(45) Veröffentlichungstag und Bekanntmachung des Hinweises auf die Patenterteilung: **08.01.2020**
(21) Anmeldenummer: 08168962.2
(22) Anmeldetag: 12.11.2008
(51) Int. Cl.: H05K 5/06

(54) **Elektroinstallationsdose und Verwendung einer Elektroinstallationsdose**
Electrical installation socket and use thereof
Prise d'installation électrique et utilisation d'une prise d'installation électrique

(30) Priorität: 13.11.2007 DE 102007054471
(43) Veröffentlichungstag der Anmeldung: 20.05.2009
(73) Patentinhaber: Günther Spelsberg GmbH & Co. KG, 58579 Schalksmühle (DE)
(72) Erfinder: Werkshagen, Bernd, 58579, Schalksmühle (DE); Spelsberg, Dipl.-Ing. Holger, 58579, Schalksmühle (DE); Deschouffour, Michael, 44629, Herne (DE); Wasserfuhr, Dipl.-Ing. Friedel, 51688, Wipperfürth (DE); Niclas, Peter, 58509, Lüdenscheid (DE); Scheib, Dipl.-Ing. Andreas, 58239, Schwerte (DE); Quardt, Dipl.-Ing. Dirk, 58638, Iserlohn (DE)
(74) Vertreter: Michalski Hüttermann & Partner Patentanwälte mbB

(56) Entgegenhaltungen:
- EP-A2- 0 187 499
- DE-A1- 3 243 495
- DE-U1- 20 205 485
- DE-U1- 20 220 318
- US-A- 4 012 874
- US-A- 4 827 502
- US-B1- 6 560 110
- US-B1- 6 964 575

## Beschreibung

Die Erfindung betrifft eine Elektroinstallationsdose, zur Aufnahme wenigstens einer elektrischen und/oder elektronischen Einrichtung, mit einem Außengehäuse und die Verwendung einer Elektroinstallationsdose.

Elektroinstallationsdosen sind in vielfältiger Ausgestaltung für unterschiedlichste Anwendungsgebiete gut bekannt. Im Allgemeinen dienen sie der Aufnahme einer elektrischen und/oder elektronischen Einrichtung, z. B. zu Verbindungs- und/oder Abzweigzwecken. Typischerweise sind der Elektroinstallationsdose dazu elektrische Leiter zugeführt, die mit der elektrischen und/oder elektronischen Einrichtung verbunden sind.

Zum Schutz der elektrischen bzw. elektronischen Einrichtung in der Elektroinstallationsdose vor Feuchtigkeit und Wassereintritt ist es aus der Praxis bekannt, den Innenraum der Elektroinstallationsdose mit einem Vergussmaterial, wie einem Gießharz, zu vergießen. Auf diese Weise wird die elektrische bzw. elektronische Einrichtung in der Elektroinstallationsdose praktisch wasserdicht gekapselt, so dass Anwendungen der Elektroinstallationsdose z. B. auch in Überschwemmungsgebieten, in Waschanlagen, in Tunneln und Hafenanlagen sowie im Gartenbau möglich werden. Insbesondere kann durch ein Vergießen des Innenraums der Elektroinstallationsdose für die elektrische bzw. elektronische Einrichtung die Realisierung der Schutzart IP 68 nach DIN EN 60529 ermöglicht werden.

Problematisch ist bei einer derartigen Vorgehensweise jedoch häufig, dass die elektrische bzw. elektronische Einrichtung nach dem Verguss nicht mehr zugänglich ist, so dass auch keine Reparatur bzw. kein Austausch einer defekten Komponente mehr durchgeführt werden kann.

Die US 6 650 110 B1 zeigt thermisch widerstandsfähige Struktur zum thermischen Management. Diese Struktur umfasst ein Substrat mit darauf angeordneten flip chips. Weiterhin ist ein thermisch leitfähiges Blockelement vorgesehen, das als Hohlkörper ausgebildet ist und derart auf dem Substrat positioniert ist, dass es mit seiner Außenfläche an den flip chips anliegt. Substrat und thermisch leitfähiges Blockelement sind in einem Kunststoffgehäuse positioniert und darin mit einem Vergussmaterial vergossen.

Daher ist es die Aufgabe der Erfindung, eine derartige Elektroinstallationsdose bereitzustellen, die wassergeschützt ist und dabei gleichzeitig einen einfachen und wiederholten Zugang zu einer in ihr angeordneten elektrischen und/oder elektronischen Einrichtung ermöglicht.

Diese Aufgabe ist durch die Gegenstände der unabhängigen Ansprüche gelöst. Bevorzugte Weiterbildungen sind in den Unteransprüchen beschrieben.

Ausgehend von der eingangs beschriebenen Elektroinstallationsdose ist diese Aufgabe insbesondere dadurch gelöst, dass in dem Außengehäuse ein Innengehäuse vorgesehen ist, die elektrische und/oder elektronische Einrichtung in dem Innengehäuse angeordnet ist, das Innengehäuse mittels eines abnehmbaren Innengehäusedeckels verschlossen ist und wenigstens der Übergangsbereich von dem Innengehäusedeckel auf das Innengehäuse mit einem Vergussmaterial vergossen ist.

Erfindungsgemäß ist also die Kombination eines Außengehäuses mit einem Innengehäuse vorgesehen, wobei das Innengehäuse die eigentliche elektrische und/oder elektronische Einrichtung aufnimmt und der Bereich zwischen dem Innengehäuse und dem Außengehäuse wenigstens teilweise vergossen wird, nämlich derart, dass wenigstens der Übergangsbereich von dem Innengehäusedeckel auf das Innengehäuse mit dem Vergussmaterial versehen wird. Mit "Übergangsbereich von dem Innengehäusedeckel auf das Innengehäuse" ist dabei vorliegend der Bereich gemeint, in dem der Innengehäusedeckel an dem Innengehäuse anliegt und wo insofern dafür Sorge getragen werden muss, dass zur Wasserdichtigkeit eine Abdichtung erfolgt.

Mit anderen Worten weist die erfindungsgemäße Elektroinstallationsdose damit ein doppelwandiges Gehäuse auf, nämlich gebildet durch das Außengehäuse und das darin angeordnete Innengehäuse. Dabei kann es sich grundsätzlich bei dem Außengehäuse und bei dem Innengehäuse um zwei voneinander völlig separate Gehäuse handeln. Gemäß einer bevorzugten Weiterbildung der Erfindung ist jedoch vorgesehen, dass wenigstens eine Wandung des Innengehäuses auch eine Wandung des Außengehäuses ist. Dies kann z. B. bedeuten, dass der Boden des Außengehäuses gleichzeitig auch der Boden des Innengehäuses ist, während das Innengehäuse von den Seitenwänden des Außengehäuses verschiedene Seitenwände aufweist und auch der Innengehäusedeckel von einem gegebenenfalls vorgesehenen Außengehäusedeckel verschieden ist.

Grundsätzlich kann es ausreichend sein, dass wenigstens der Übergangsbereich von dem Innengehäusedeckel auf das Innengehäuse mit einem Vergussmaterial vergossen ist. Gemäß einer bevorzugten Weiterbildung der Erfindung ist jedoch vorgesehen, dass wenigstens der Innengehäusedeckel vollständig vergossen ist.

Wie weiter oben schon ausgeführt, ist häufig vorgesehen, dass der elektrischen und/oder elektronischen Einrichtung in der Elektroinstallationsdose ein elektrischer Leiter zugeführt ist. Eine Abdichtung der Zuführung des elektrischen Leiters kann dabei grundsätzlich auf verschiedene Weisen erzielt werden. Gemäß einer bevorzugten Weiterbildung der Erfindung ist jedoch vorgesehen, dass in dem Fall, dass der elektrischen und/oder elektronischen Einrichtung wenigstens ein elektrischer Leiter zugeführt ist, wenigstens auch der Bereich der Einführung des elektrischen Leiters in das Innengehäuse vergossen ist. Dies bedeutet, dass gemäß dieser bevorzugten Weiterbildung der Erfindung wenigstens der Bereich mit einem Vergussmaterial versehen ist, in dem der elektrische Leiter in das Innengehäuse hineingeführt ist, so dass es praktisch zu einer Abdichtung des Einführungsbereichs kommt.

Wie zuvor schon angedeutet, kann es grundsätzlich ausreichend sein, dass das Innengehäuse nur teilweise vergossen ist. Gemäß einer bevorzugten Weiterbildung der Erfindung ist jedoch vorgesehen, dass das Innengehäuse vollständig vergossen ist. Insbesondere ist es ganz besonders bevorzugt, dass der freie Raum des Außengehäuses vollständig mit Vergussmaterial ausgefüllt ist. Mit anderen Worten wird auf diese Weise eine derartige Ausgestaltung der erfindungsgemäßen Elektroinstallationsdose erzielt, bei der das Innengehäuse, nachdem in diesem die elektrische und/oder elektronische Einrichtung installiert worden ist, vollständig vergossen wird, indem der verbleibende Raum in dem Außengehäuse vollständig mit dem Vergussmaterial aufgefüllt wird.

Der Innengehäusedeckel kann grundsätzlich unterschiedlich angeordnet und ausgebildet sein, insbesondere hinsichtlich seiner Form und seiner Anbringung auf dem Innengehäuse. Gemäß einer bevorzugten Weiterbildung der Erfindung ist vorgesehen, dass der Innengehäusedeckel derart angeordnet und ausgebildet ist, dass er nach wenigstens teilweiser Entfernung des Vergussmaterials abgenommen werden kann. Auf diese Weise wird die Möglichkeit erzielt, auf einfache Weise Zugriff auf den Innenraum des Innengehäuses zu erhalten, um z. B. eine Reparatur durchzuführen oder um ein Bauteil auszutauschen.

Grundsätzlich kann nach einer derartigen Reparatur bzw. nach dem Austausch eines Bauteils nunmehr z. B. auch das Innengehäuse vergossen werden. Gemäß einer bevorzugten Weiterbildung der Erfindung ist jedoch vorgesehen, dass der Innengehäusedeckel derart angeordnet und ausgebildet ist, dass er auch wieder auf das Innengehäuse zum Verschließen desselben aufgesetzt werden kann. Auf diese Weise ist es nämlich möglich, das entfernte Vergussmaterial zu ersetzen, um im Ergebnis zu praktisch der gleichen Ausgestaltung der Elektroinstallationsdose zu kommen, bei der das Innengehäuse durch das dieses umgebende Vergussmaterial geschützt ist.

In diesem Zusammenhang ist es gemäß einer bevorzugten Weiterbildung der Erfindung insbesondere vorgesehen, dass der Innengehäusedeckel auf das Innengehäuse auf Passung aufgeklemmt ist. Auf diese Weise kann erreicht werden, dass keine weiteren Maßnahmen ergriffen werden müssen, um zu verhindern, dass das Vergussmaterial in den Innenraum des Innengehäuses gelangt.

Grundsätzlich sind unterschiedliche Arten von Vergussmaterialien verwendbar. Gemäß einer bevorzugten Weiterbildung der Erfindung ist jedoch vorgesehen, dass das Vergussmaterial schneidbar ist. Dies kann insbesondere dann erzielt werden, wenn als Vergussmaterial ein silikonartiges Gießharz verwendet wird. Ein derartiges Gießharz kann z. B. mit einem Messer, wie einem Skalpell, geschnitten werden. In diesem Zusammenhang ist es gemäß einer bevorzugten Weiterbildung der Erfindung auch vorgesehen, dass das Vergussmaterial elastisch verformbar ist. Dies hat ferner den Vorteil, dass Stöße auf die Elektroinstallationsdose von dem Vergussmaterial abgefedert werden können.

Mit der zuvor beschriebenen Elektroinstallationsdose ist nun insbesondere folgende Vorgehensweise möglich:
Nachdem eine elektrische und/oder elektronische Einrichtung in dem Innengehäuse angeordnet worden ist, wird das Innengehäuse verschlossen, indem der Innengehäusedeckel aufgesetzt wird. Nun wird der verbleibende Raum in dem Außengehäuse, also der Raum, der das Innengehäuse im Außengehäuse umgibt, mit einem Vergussmaterial aufgefüllt, so dass das Innengehäuse z. B. vollständig von dem Vergussmaterial bedeckt ist. Gegebenenfalls kann das Außengehäuse dann mit einem Außengehäusedeckel verschlossen werden.

Ergibt sich nun die Notwendigkeit, auf den Innenraum des Innengehäuses zugreifen zu müssen, z. B. weil die dort vorgesehene elektrische und/oder elektronische Einrichtung repariert oder ausgetauscht werden muss, so kann der Außengehäusedeckel abgenommen werden, um Zugriff auf das Vergussmaterial zu erhalten. Dieses wird dann zumindest so weit herausgetrennt, z. B. herausgeschnitten, dass man Zugriff auf den Innengehäusedeckel bekommt, der damit abgenommen werden kann. Nunmehr kann der Austausch bzw. die Reparatur der elektrischen und/oder elektronischen Baueinrichtung erfolgen.

Danach kann der Innengehäusedeckel wieder auf das Innengehäuse aufgesetzt werden, und der Schutz des Innengehäuses kann schließlich durch Ersetzen des herausgeschnittenen Vergussmaterials durch neuen Verguss wieder hergestellt werden. Nachdem auch der Außengehäusedeckel aufgesetzt worden ist, erhält man eine wieder einsatzfähige Elektroinstallationsdose, der man die Reparatur bzw. den Austausch der elektrischen und/oder elektronischen Einrichtung nicht ohne weiteres ansehen kann.

Die weiter oben genannte Aufgabe ist insofern insbesondere auch gelöst durch eine Verwendung einer wenigstens eine elektrische und/oder elektronische Einrichtung aufweisenden Elektroinstallationsdose zum Schutz der elektrischen bzw. elektronischen Einrichtung vor Feuchtigkeit und Wassereintritt, wobei die Elektroinstallationsdose ein Außengehäuse aufweist, in dem ein Innengehäuse vorgesehen ist, die elektrische und/oder elektronische Einrichtung in dem Innengehäuse angeordnet ist, das Innengehäuse mittels eines abnehmbaren Innengehäusedeckels verschlossenes ist und wenigstens der Übergangsbereich von dem Innengehäusedeckel auf das Innengehäuse mit einem Vergussmaterial vergossen ist.

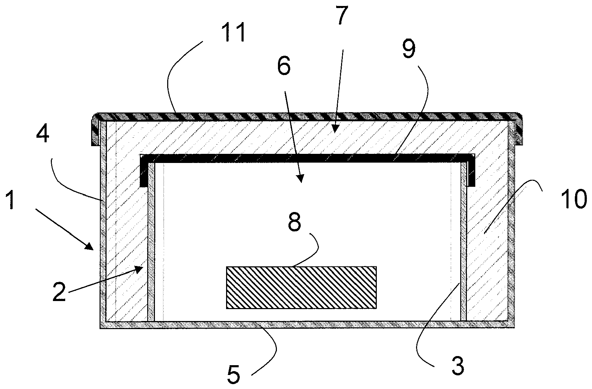

Nachfolgend wird die Erfindung unter Bezugnahme auf ein bevorzugtes Ausführungsbeispiel anhand der Zeichnung näher erläutert. In der Zeichnung zeigt die einzige Figur eine Elektroinstallationsdose gemäß einem bevorzugten Ausführungsbeispiel der Erfindung schematisch in einer Schnittdarstellung.

Wie aus der Figur ersichtlich, ist gemäß dem bevorzugten Ausführungsbeispiel der Erfindung eine Elektroinstallationsdose mit einem Außengehäuse 1 und einem Innengehäuse 2 vorgesehen. Dabei sind die Außenwände 3 des Innengehäuses 2 innerhalb des Außengehäuses 1 vorgesehen, also innerhalb der Außenwände 4 des Außengehäuses 1 und im Abstand von diesen. Nach unten hin wird die Elektroinstallationsdose von einem Boden 5 abgeschlossen, der sowohl den Boden des Außengehäuses 1 als auch den Boden des Innengehäuses 2 darstellt. Auf diese Weise ergibt sich praktisch eine doppelwandige Elektroinstallationsdose mit einem Innenraum 6 innerhalb des Innengehäuses 2 und einem Außenraum 7, insbesondere gebildet durch den Raum zwischen den Außenwänden 3 des Innengehäuses 2 und den Außenwänden 4 des Außengehäuses 1 sowie durch den Bereich über dem Innengehäuse 2.

In dem Innenraum 6 des Innengehäuses 2 ist eine elektronische Einrichtung 8 vorgesehen. Um diese vor Wasser zu schützen, insbesondere um diesbezüglich die Schutzart IP 68 zu erzielen, ist das Innengehäuse 2 mit einem Innengehäusedeckel 9 verschlossen, der auf Passung auf das Innengehäuse 2 aufgesetzt ist. Ferner ist der zuvor angesprochene Außenraum 7 gemäß dem vorliegend beschriebenen bevorzugten Ausführungsbeispiel der Erfindung vollständig mit einem Vergussmaterial 10 vergossen, vorliegend nämlich mit einem silikonartigen, elastischen Gießharz. Schließlich ist die Elektroinstallationsdose nach außen hin mittels eines Außengehäusedeckels 11 abgeschlossen, der ebenfalls auf Passung auf das Außengehäuse 1 aufgesetzt ist.

Wie zuvor schon ausgeführt, ist es auf diese Weise möglich, nach dem Verguss des Innengehäuses 2 gleichwohl wieder auf die in diesem angeordnete elektronische Einrichtung 8 zuzugreifen, und zwar indem der Verguss oberhalb des Innengehäusedeckels 9 entfernt und dann der Innengehäusedeckel 9 abgenommen wird. Danach kann der Zustand gemäß Schutzart IP 68 wieder hergestellt werden, indem der herausgetrennte Bereich neu vergossen wird.

## Patentansprüche

1. Elektroinstallationsdose, zur Aufnahme wenigstens einer elektrischen und/oder elektronischen Einrichtung (8), mit einem Außengehäuse (1), **dadurch gekennzeichnet, dass** in dem Außengehäuse (1) ein Innengehäuse (2) vorgesehen ist, die elektrische und/oder elektronische Einrichtung (8) in dem Innengehäuse (2) angeordnet ist, das Innengehäuse (2) mittels eines abnehmbaren Innengehäusedeckels (9) verschlossen ist und wenigstens der Übergangsbereich von dem Innengehäusedeckel (9) auf das Innengehäuse (2) mit einem Vergussmaterial (10) vergossen ist, wobei der Übergangsbereich der Bereich ist, in dem der Innengehäusedeckel (9) an dem Innengehäuse (2) anliegt und wo insofern dafür Sorge getragen werden muss, dass zur Wasserdichtigkeit eine Abdichtung erfolgt.

2. Elektroinstallationsdose nach Anspruch 1, **dadurch gekennzeichnet, dass** wenigstens der Innengehäusedeckel (9) vollständig vergossen ist.

3. Elektroinstallationsdose nach Anspruch 1 oder 2, **dadurch gekennzeichnet, dass** der elektrischen und/oder elektronischen Einrichtung (8) wenigstens ein elektrischer Leiter zugeführt ist, wobei wenigstens auch der Bereich der Einführung des elektrischen Leiters in das Innengehäuse (2) vergossen ist.

4. Elektroinstallationsdose nach einem der Ansprüche 1 bis 3, **dadurch gekennzeichnet, dass** der Innengehäusedeckel (9) derart angeordnet und ausgebildet ist, dass er nach wenigstens teilweiser Entfernung des Vergussmaterials (10) abnehmbar ist.

5. Elektroinstallationsdose nach einem der Ansprüche 1 bis 4, **dadurch gekennzeichnet, dass** das Vergussmaterial (10) schneidbar ist

6. Elektroinstallationsdose nach einem der Ansprüche 1 bis 5, **dadurch gekennzeichnet, dass** das Vergussmaterial (10) elastisch verformbar ist.

7. Elektroinstallationsdose nach einem der Ansprüche 1 bis 6, **dadurch gekennzeichnet, dass** wenigstens eine Wandung des Innengehäuses (2) auch eine Wandung des Außengehäuses (1) ist.

8. Verwendung einer wenigstens eine elektrische und/oder elektronische Einrichtung (8) aufweisenden Elektroinstallationsdose zum Schutz der elektrischen bzw. elektronischen Einrichtung (8) vor Feuchtigkeit und Wassereintritt, wobei die Elektroinstallationsdose ein Außengehäuse (1) aufweist, in dem ein Innengehäuse (2) vorgesehen ist, die elektrische und/oder elektronische Einrichtung (8) in dem Innengehäuse (2) angeordnet ist, das Innengehäuse (2) mittels eines abnehmbaren Innengehäusedeckels (9) verschlossen ist und wenigstens der Übergangsbereich von dem Innengehäusedeckel (9) auf das Innengehäuse (2) mit einem Vergussmaterial (10) vergossen ist, wobei der Übergangsbereich der Bereich ist, in dem der Innengehäusedeckel (9) an dem Innengehäuse (2) anliegt und wo insofern dafür Sorge getragen werden muss, dass zur Wasserdichtigkeit eine Abdichtung erfolgt.

9. Verwendung nach Anspruch 8, **dadurch gekennzeichnet, dass** wenigstens der Innengehäusedeckel (9) vollständig vergossen ist.

10. Verwendung nach Anspruch 8 oder 9, **dadurch gekennzeichnet, dass** der elektrischen und/oder elektronischen Einrichtung (8) wenigstens ein elektrischer Leiter zugeführt ist, wobei wenigstens auch der Bereich der Einführung des elektrischen Leiters in das Innengehäuse (2) vergossen ist.

11. Verwendung nach einem der Ansprüche 8 bis 10, **dadurch gekennzeichnet, dass** das Innengehäuse (2) vollständig vergossen ist.

12. Verwendung nach einem der Ansprüche 8 bis 11, **dadurch gekennzeichnet, dass** der freie Raum des Außengehäuses (1) vollständig mit Vergussmaterial (10) ausgefüllt ist.

13. Verwendung nach einem der Ansprüche 8 bis 12, **dadurch gekennzeichnet, dass** der Innengehäusedeckel (9) derart angeordnet und ausgebildet ist, dass er nach wenigstens teilweiser Entfernung des Vergussmaterials (10) abnehmbar ist.

14. Verwendung nach Anspruch 13, **dadurch gekennzeichnet, dass** der Innengehäusedeckel (9) derart angeordnet und ausgebildet ist, dass er wieder auf das Innengehäuse (2) zum Verschließen desselben aufsetzbar ist.

## Claims

1. An electrical junction box for receiving at least one electrical and/or electronic device (8), comprising an outer housing (1), **characterised in that** an inner housing (2) is provided in the outer housing (1), the electrical and/or electronic device (8) is arranged in the inner housing (2), the inner housing (2) is closed by means of a detachable inner housing lid (9), and at least the transition region from the inner housing lid (9) to the inner housing (2) is potted with a potting material (10), wherein the transition region is the region in which the inner housing lid (9) abuts the inner housing (2) and where in this regard it must be ensured that a watertight seal is provided.

2. The electrical junction box according to claim 1, **characterised in that** at least the inner housing lid (9) is fully potted.

3. The electrical junction box according to claim 1 or 2, **characterised in that** at least one electrical conductor is supplied to the electrical and/or electronic device (8), wherein at least also the region of insertion of the electrical conductor into the inner housing (2) is potted.

4. The electrical junction box according to any one of claims 1 to 3, **characterised in that** the inner housing lid (9) is arranged and designed in such a way that it is detachable after at least partial removal of the potting material (10).

5. The electrical junction box according to any one of claims 1 to 4, **characterised in that** the potting material (10) is cuttable.

6. The electrical junction box according to any one of claims 1 to 5, **characterised in that** the potting material (10) is elastically deformable.

7. The electrical junction box according to any one of claims 1 to 6, **characterised in that** at least one wall of the inner housing (2) is also a wall of the outer housing (1).

8. Use of an electrical junction box comprising at least one electrical and/or electronic device (8) for protection of the electrical and/or electronic device (8) against moisture and water ingress, wherein the electrical junction box comprises an outer housing (1), in which an inner housing (2) is provided, the electrical and/or electronic device (8) is arranged in the inner housing (2), the inner housing (2) is closed by means of a detachable inner housing lid (9), and at least the transition region from the inner housing lid (9) to the inner housing (2) is potted with a potting material (10), wherein the transition region is the region in which the inner housing lid (9) abuts the inner housing (2) and where in this regard it must be ensured that a watertight seal is provided.

9. The use according to claim 8, **characterised in that** at least the inner housing lid (9) is fully potted.

10. The use according to claim 8 or 9, **characterised in that** at least one electrical conductor is supplied to the electrical and/or electronic device (8), wherein at least also the region of the insertion of the electrical conductor into the inner housing (2) is potted.

11. The use according to any one of claims 8 to 10, **characterised in that** the inner housing (2) is fully potted.

12. The use according to any one of claims 8 to 11, **characterised in that** the free space of the outer housing (1) is completely filled with potting material (10).

13. The use according to any one of claims 8 to 12, **characterised in that** the inner housing lid (9) is arranged and designed in such a way that it is detachable after at least partial removal of the potting material (10).

14. The use according to claim 13, **characterised in that** the inner housing lid (9) is arranged and designed in such a way that it is re-fittable onto the inner housing (2) to close same.

## Revendications

1. Boîtier d'installation électrique destiné à la réception d'au moins un dispositif (8) électrique et/ou électronique, avec un boîtier extérieur (1), **caractérisé en ce qu'**un boîtier intérieur ((2) est prévu dans le boîtier extérieur (1), le dispositif (8) électrique et/ou électronique est disposé dans le boîtier intérieur (2), le boîtier intérieur (2) est fermé au moyen d'un couvercle de boîtier intérieur (9) amovible et au moins la zone de transition du couvercle de boîtier intérieur (9) est scellée sur le boîtier intérieur (2) avec un matériau de scellement (10), où la zone de transition est la zone dans laquelle le couvercle de boîtier intérieur (9) est adjacent au boîtier intérieur (2) et où il faut donc faire attention à ce qu'une étanchéité soit réalisée pour assurer l'étanchéité à l'eau.

2. Boîtier d'installation électrique selon la revendication 1, **caractérisé en ce qu'**au moins le couvercle de boîtier intérieur (9) est totalement scellé.

3. Boîtier d'installation électrique selon la revendication 1 ou la revendication 2, **caractérisé en ce qu'**au moins un conducteur électrique est mené jusqu'au dispositif (8) électrique et/ou électronique, où au moins également la zone d'insertion du conducteur électrique est scellée dans le boîtier intérieur (2).

4. Boîtier d'installation électrique selon l'une des revendications 1 à 3, **caractérisé en ce que** le couvercle de boîtier intérieur (9) est disposé et conçu de telle manière qu'il peut être enlevé au moins après un enlèvement partiel du matériau de scellement (10).

5. Boîtier d'installation électrique selon l'une des revendications 1 à 4, **caractérisé en ce que** le matériau de scellement (10) peut être coupé.

6. Boîtier d'installation électrique selon l'une des revendications 1 à 5, **caractérisé en ce que** le matériau de scellement (10) est déformable élastiquement.

7. Boîtier d'installation électrique selon l'une des revendications 1 à 6, **caractérisé en ce qu'**au moins une paroi du boîtier intérieur (2) est également une paroi du boîtier extérieur (1).

8. Utilisation d'au moins un dispositif (8) électrique et/ou électronique présentant un boîtier d'installation électrique destinée à la protection du dispositif (8) électrique, respectivement électronique vis-à-vis de l'humidité et d'une pénétration d'eau, où le boîtier d'installation électrique présente un boîtier extérieur (1) dans lequel est prévu un boîtier intérieur (2), le dispositif (8) électrique et/ou électronique est disposé dans le boîtier intérieur (2), le boîtier intérieur (2) est fermé au moyen d'un couvercle de boîtier intérieur (9) amovible et au moins la zone de transition du couvercle de boitier intérieur (9) est scellée sur le boitier intérieur (2) avec un matériau de scellement (10), où la zone de transition est la zone dans laquelle le couvercle de boîtier intérieur (9) est adjacent au boîtier intérieur (2) et où il faut donc faire attention à ce qu'une étanchéité soit réalisée pour assurer l'étanchéité à l'eau.

9. Utilisation selon la revendication 8, **caractérisée en ce qu'**au moins le couvercle de boîtier intérieur (9) est totalement scellé.

10. Utilisation selon la revendication 8 ou la revendication 9, **caractérisée en ce qu'**au moins un conducteur électrique est mené jusqu'au dispositif (8) électrique et/ou électronique, où au moins également la zone d'insertion du conducteur électrique est scellée dans le boîtier intérieur (2) .

11. Utilisation selon l'une des revendications 8 à 10, **caractérisée en ce que** le boîtier intérieur (2) est totalement scellé.

12. Utilisation selon l'une des revendications 8 à 11, **caractérisée en ce que** l'espace libre du boîtier extérieur (1) est totalement rempli avec le matériau de scellement (10).

13. Utilisation selon l'une des revendications 8 à 12, **caractérisée en ce que** le couvercle de boîtier intérieur (9) est disposé et est conçu de telle manière qu'il peut être enlevé après au moins un retrait partiel du matériau de scellement (10).

14. Utilisation selon la revendication 13, **caractérisée en ce que** le couvercle de boîtier intérieur (9) est disposé et est conçu de telle manière qu'il peut de nouveau être placé sur le boitier intérieur (2) pour fermer celui-ci.
